## Europäisches Patentamt
## European Patent Office
## Office européen des brevets

(11) Publication number: **0 137 245**
**B1**

(12) # EUROPEAN PATENT SPECIFICATION

(45) Date of publication of patent specification: **14.03.90**

(51) Int. Cl.⁵: **G 11 C 17/00**

(21) Application number: **84109957.5**

(22) Date of filing: **21.08.84**

(54) Semiconductor integrated circuit.

(30) Priority: **30.08.83 JP 158723/83**
**08.09.83 JP 164112/83**
**13.02.84 JP 24581/84**
**23.04.84 JP 81289/84**
**13.08.84 JP 168985/84**

(43) Date of publication of application:
**17.04.85 Bulletin 85/16**

(45) Publication of the grant of the patent:
**14.03.90 Bulletin 90/11**

(84) Designated Contracting States:
**DE FR GB**

(56) References cited:
**EP-A-0 092 809**
**GB-A-2 094 086**
**US-A-4 442 481**

**PATENTS ABSTRACTS OF JAPAN, vol. 7, no.
224 (P-227)1369r, 5th October 1983; & JP-A-58
114 396**

(73) Proprietor: **KABUSHIKI KAISHA TOSHIBA
72, Horikawa-cho Saiwai-ku
Kawasaki-shi Kanagawa-ken 210 (JP)**
(73) Proprietor: **Toshiba Micro-Computer
Engineering Corporation
2-11, Higashida-cho Kawasaki-ku
Kawasaki-shi Kanagawa-ken (JP)**
(73) Proprietor: **Tosbac Computer System Co., Ltd.
Shibuya-Takugin-Building 1-13-9, Shibuya
Shibuya-ku
Tokyo (JP)**

(72) Inventor: **Iwahashi, Hiroshi c/o Patent Division
KABUSHIKI KAISHA TOSHIBA 1-1 Shibaura
1-chome
Minato-ku Tokyo 105 (JP)**
Inventor: **Asano, Masamichi c/o Patent Division
KABUSHIKI KAISHA TOSHIBA 1-1 Shibaura
1-chome
Minato-ku Tokyo 105 (JP)**
Inventor: **Momodomi, Masaki c/o Patent
Division
KABUSHIKI KAISHA TOSHIBA 1-1 Shibaura
1-chome
Minato-ku Tokyo 105 (JP)**
Inventor: **Minagawa, Hidenobu
1 Daini-Taiyo-So 194 Kariyado Nakahara-ku
Kawasaki-shi (JP)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 137 245 B1**

56 References cited:

ELECTRONIC DESIGN, vol. 31, no. 17, 18th August 1983, pages 189-196, Waseca, MN, Denville, NJ, US; F. JONES et al.: "EEPROM adapts easily to in-system changes"

IBM TECHNICAL DISCLOSURE BULLETIN, vol. 25, no. 12, May 1983, pages 6723,6724, New York, US; H.C. CRANFORD et al.: "High voltage driver circuit in MOSFET technology"

IEEE INTERNATIONAL SOLID STATE CIRCUITS CONFERENCE, vol. 25, February 1982, pages 184,185,317, New York, US; A. GUPTA et al.: "A 5V-only 16K EEPROM utilizing oxynitride dielectrics and EPROM redundancy"

IEEE JOURNAL OF SOLID-STATE CIRCUITS, vol. SC-18, no. 5, October 1983, pages 539-544, IEEE, New York, US; E.M. LUCERO et al.: "A 16 kbit smart 5 V-only EEPROM with redundancy"

72 Inventor: Suzuki, Kazuto
605, Nakamaruko Nakahara-ku
Kawasaki-shi (JP)
Inventor: Narita, Akira
1-42, Furuichiba Saiwai-ku
Kawasaki-shi (JP)

74 Representative: Henkel, Feiler, Hänzel & Partner
Möhlstrasse 37
D-8000 München 80 (DE)

## Description

The present invention relates to a semiconductor integrated circuit which selectively supplies a high voltage in response to an input control signal.

An electrically erasable and programmable read only memory (E²PROM) which has a floating gate and a control gate to electrically rewrite the stored content has recently prevailed instead of a conventional ultraviolet ray erasable semiconductor memory. The electric rewriting of this memory is executed by injecting electrons to a floating gate by a tunnel effect through an extremely thin oxidized film or by emitting, on the other hand, electrons of the floating gate. A writing voltage higher than a reading voltage applied at a reading time is required at the rewriting time utilizing a tunnel current, but, in this case, almost no electric power is consumed. Thus, a voltage-boost circuit (charge pump circuit) is provided in a chip to internally generate a high voltage different from that at the reading time, thereby writing at this high voltage and erasing. Since this necessitates only a sole power source of, for example, 5 volts at an external power source, a user can vary readily handle it.

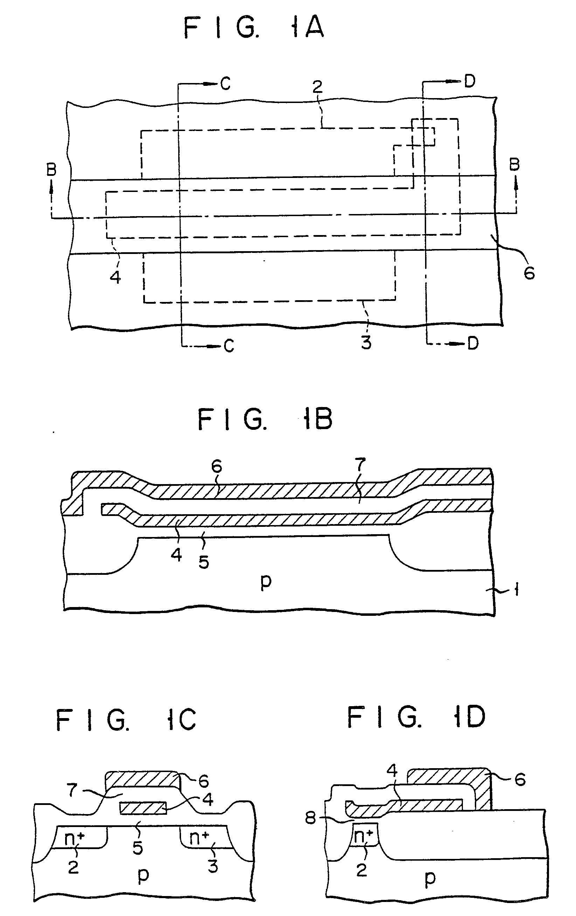

An example of a memory cell of such an E²PROM is shown in Figs. 1A to 1D. Fig. 1A shows a plan view, and Figs. 1B to 1D are sectional views respectively taken along the lines B-B, C-C and D-D in the E²PROM shown in Fig. 1A. This E²PROM has an $n^+$-type drain 2 formed in the surface region of a p-type Si substrate, an $n^+$-type source 3 formed in the surface region of a p-type Si substrate, a floating gate 4 formed through a thin gain oxidized film 5 on a channel region, and a control gate 6 formed through a gate oxidized film 7 on the floating gate 4. As shown in Fig. 1D, part of the floating gate 5 is extended through an extremely thin oxidized film 8 on an $n^+$-type layer extended from the drain 2 to form a rewriting region.

A principle of the operation of the memory cell is as follows: In the writing operation, the drain 2 and the source 3 are maintained at a zero voltage, a high voltage is applied to the control gate 6 to raise the voltage of the floating gate 4 by capacitive coupling, and electrons from the $n^+$-type drain 2 is injected to the floating gate 4 thorugh the extremely thin oxidized film 8 in the rewriting region. In the erasure, the control gate 6 is maintained at zero voltage, a high voltage is applied to the drain 2, and the electrons of the floating gate 4 are emitted on the contrary to the case of the writing. Since the threshold voltage of the memory cell becomes high even if a voltage of 5 volts is, for example, applied as a reading voltage to the control gate 6 in the state that the electrons are injected to the floating gate 4, the memory cell does not beome ON. When the reading voltage of 5 volts is applied to the control gate 6 in the state that the electrons are not stored in the floating gate 4, the memory cell becomes ON. Thus, the memory cell selectively stores data "1" or "0".

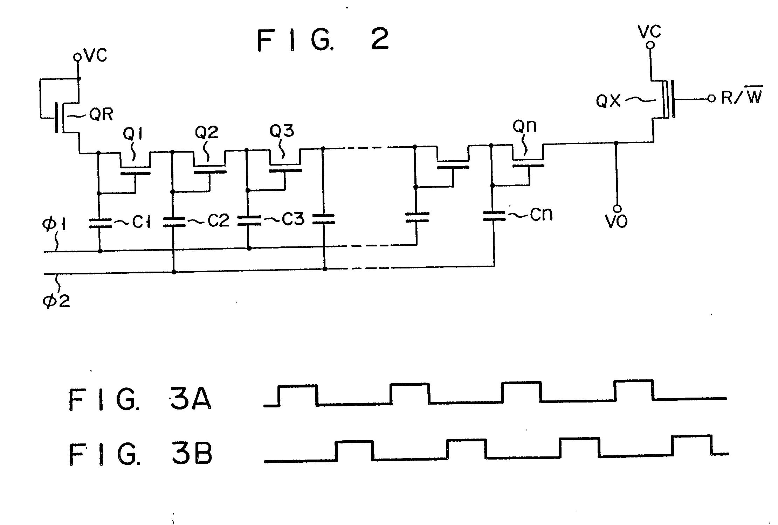

Such memory cells are arranged in row and column directions in a matrix, the control gates are, for example, commonly connected in the row direction, and the drains and sources are commonly connected in the column direction to compose a memory cell array. In order to produce a high voltage for program (writing and erasing) by stepping up a power source voltage in a chip, a charge pump circuit as shown in Fig. 2 is, for example, employed.

This charge pump circuit has n stages of step-up section coupled between a load MOSFET QR and an output terminal VO, and a depletion type MOSFET QX coupled between a power source terminal VC and the output terminal VO. Each stage of the step-up section has one of MOSFETs Q1 to Qn, and one of capacitors C1 to Cn coupled at one end of the gate and the drain of this MOSFET. A clock pulse φ1 shown in Fig. 3(A) is applied to the other terminals of the capacitors in the odd-numbered stages of the step-up sections, and a clock pulse φ2 having a predetermined phase difference to the clock pulse φ1, shown in Fig. 3(B) is applied to the other terminals of the capacitors in the even stages.

In this charge pump circuit, a high voltage, for example, 20 volts is obtained at the output terminal VO by sequentially repeating the operation such that the charge stored in the capacitor C1 through the load MOSFET QR from the power source VC is transferred to the next capacitor C2 through the MOSFET Q1 by applying the clocks φ1, φ2 as shown in Fig. 3 and the charge of this capacitor C2 is transferred to the next capacitor C3 through the MOSFET Q2.

When such a charge pump circuit is rewritten by applying a high voltage to a selected row of a memory cell array in combination with an address decoder, the following problem has arisen. There is no trouble in the supply of the high voltage thus stepped-up to the control gate of the row selected by the fact that the output of the address decoder becomes high. As the charge pump circuit in fig. 2 utilizes the charge stored in the capacitor, the current supplying ability of the capacitor is extremely low. When the outputs of the address decoders are at a low level in the remaining rows not selected, the current from this charge pump circuit must not flow out through the output stage. Therefore, if the above-described current flowout occurs in the rows not selected, a sufficient high voltage cannot be applied to the row thus selected.

Prior art document GB—A—2 094 086 discloses a non-volatile semiconductor memory system in which a write circuit is comprised of a first D type MOS transistor of which the source-drain path is inserted between a boosted voltage applying terminal and a first node, and the gate is coupled with the signal from this first node, an inverter including a second D type MOS transistor of which the source-drain path is inserted a voltage applying terminal and the output terminal of the inverter and the gate is coupled with the output of the inverter an E type MOS transistor of which the source-drain path is connected between the output terminal of the inverter and earth potential a the gate is connected to the first node, a thir type MOS transistor of which the source-drain path is inserted between the voltage applying terminal and a second node and the gate is coupled with the output from the inverter, and a fourth D type MOS transistor of which the source-drain path is inserted between the first and second nodes and the gate is connected to the first node. The third D type MOS transistor is desirable to be an enhancement type, and the fourth D type MOS transistor may be replaced by a simple resistive component.

Further, Patent Abstracts of Japan. Vol. 7, No. 224 (P-227) 1369, 5 October 1983 and JP—A—58 114 396 describe a non-volatile memory in which an enhancement type p-channel MOS transistor is connected between a high voltage supplying terminal and an output terminal. The gate of this MOS transistor is connected to the output of a CMOS inverter.

It is an object of the present invention to provide a semiconductor integrated circuit capable of suppressing the current flowout from a charge pump circuit to the minimum and supplying a sufficiently stepped-up voltage to a memory cell array, thereby improving the reliability.

In order to achieve the above and other objects, there is provided according to the present invention a semiconductor integrated circuit as defined in claim 1 or 6.

The present invention provides a semiconductor integrated circuit which has a simple arrangement and can suppress the current consumption to the minimum.

This invention can be more fully understood from the following detailed description when taken in conjunction with the accompanying drawings, in which:

Fig. 1A is a plan view of a memory cell having a conventional floating gate;

Figs. 1B to 1D are sectional views showing the constructions of the memory cell taken along the lines B-B, C-C and D-D in Fig. 1A;

Fig. 2 is a circuit diagram showing a charge pump circuit for selectively generating a step-up voltage and a power source voltage;

Fig. 3 is a waveform diagram of drive pulses for driving the charge pump circuit shown in Fig. 2;

Fig. 4 is a block diagram of a memory device using a semiconductor integrated circuit according to an embodiment of the present invention;

Fig. 5 is a circuit diagram of a semiconductor integrated circuit according to an embodiment of the present invention;

Fig. 6 is a circuit diagram of a modified embodiment of the circuit shown in Fig. 5;

Fig. 7 is a circuit diagram of a semiconductor integrated circuit according to another embodiment of the present invention;

Fig. 8 is a circuit diagram showing modified embodiments of the present invention shown in Fig. 7; and

Fig. 9 is a circuit diagram showing a semiconductor integrated circuit according to still another embodiment of the present invention.

The present invention will now be described in more detail with reference to the accompanying drawings.

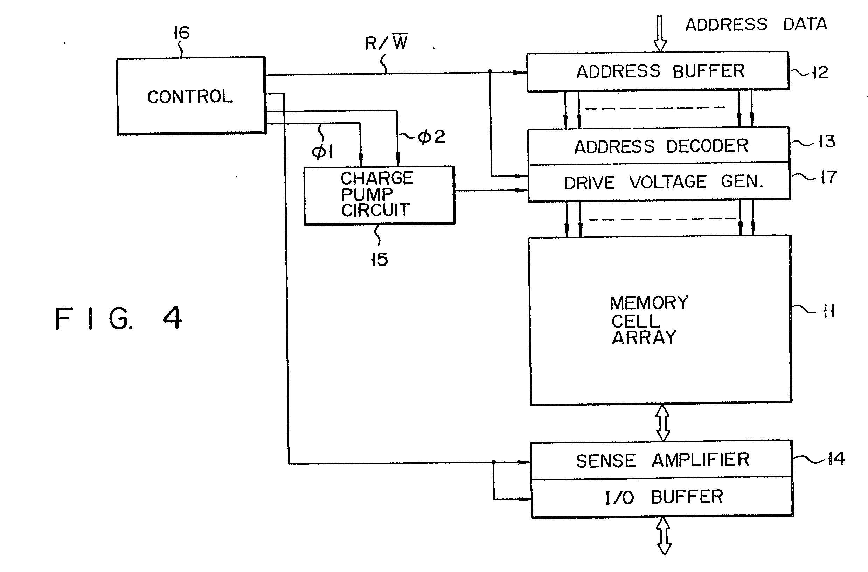

Fig. 4 shows a semiconductor memory device using a semiconductor integrated circuit according to an embodiment of the present invention. This semiconductor memory device comprises a memory cell array 11, an address buffer 12, an address decoder 13, an I/O circuit 14 including an I/O buffer and a sense amplifier, a charge pump circuit 15 for generating high level voltage and a control circuit 16 for controlling the operations of these units and circuits. A semiconductor memory device having these constituents 11 to 16 is heretofore known. The memory cell array has the memory cells described with reference to Figs. 1A to 1D and arranged in a matrix form, and the charge pump circuit 15 has the circuit as shown in Fig. 2. The point of the semiconductor memory device different from the conventional one is that a step-up drive voltage generation circuit 17 is provided at the output terminal of the address decoder 13. This step-up drive voltage generation circuit 17 is operated to supply a high voltage (e.g., VH=20 volts) stepped up from a power source voltage in case of rewriting and to supply a reading voltage substantially equal to the power source voltage in case of reading to the selected row of the memory cell array 11 in the case that the output of the decoder 13 is "1", and to supply zero voltage without flowing out a current to the remaining nonselected rows in the case that the output of the decoder 13 is "0".

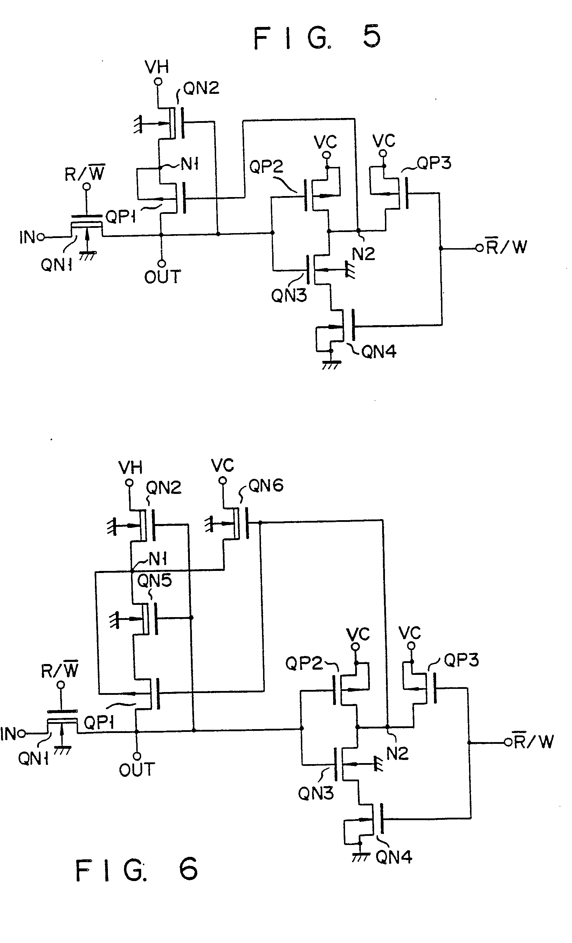

An example of a concrete construction of the step-up drive voltage generation circuit 17 is shown in Fig. 5. Fig. 5 shows a unit circuit section connected to one output terminal of the decoder 13, and similar circuits are respectively provided at the output terminals of the decoder 13. In other words, an input terminal IN is a terminal connected to one output terminal of the decoder 13, and an output terminal OUT is a terminal for supplying a selected signal voltage to the control gate of the selected row of the memory cell array 11. An n-channel depletion type (D-type) MOSFET QN1 controlled by a read/write control signal R/$\overline{W}$ is provided as a transfer gate between the input terminal IN and the output terminal OUT. The output voltage of the charge pump circuit 15 is supplied to a step-up voltage (high voltage) receiving terminal VH, and a p-channel enhancement type (E-type) MOSFET QP1 and an n-channel D-type MOSFET QN2 are connected in series between the output terminal OUT and the step-up voltage erceiving terminal VH. A substrate of the MOSFET QP1 is connected to a connecting node N1 between these MOSFETs QP1 and QN2, and the gate of the MOSFET QN2 is coupled to the output terminal OUT. On the other hand, the output terminal OUT is connected to the input terminal of a CMOS inverter having an n-channel E-type MOSFET QN3 and a p-channel E-type MOSFET QP2, and the output node N2 of the CMOS inverter is coupled to the gate of the MOSFET QP1. An n-channel E-type MOSFET QN4 is provided in series with the MOSFET QN3 at the ground side of the CMOS inverter, a p-channel E-type MOSFET QP3 is provided in parallel with the MOSFET QP2 at the power source VC side, and the gates of these MOSFETs QN4 and QP3 are controlled by an inverted signal $\overline{R}$/W of the read/write control signal R/$\overline{W}$.

An operation of the circuit shown in Fig. 5 will be described. The threshold value of the n-channel D-type MOSFETs QN1 and QN2 is −3 volts, the threshold value of the n-channel E-type MOSFETs QN3 and QN4 is 1 volt, and the threshold value of the p-channel E-type MOSFETs QP1, QP2 and QP3 is −1 volt.

A writing mode will be first described. $\overline{R}$/W=5 volts and R/$\overline{W}$=0 volt are applied in the writing mode, and a step-up voltage of 20 volts is supplied from the charge pump circuit 15 to the terminal VH. Assume now that the input terminal IN is 5 volts, i.e., the output of the decoder is "1" level, a voltage of approx. 3 volts is presented at the output terminal OUT according to the threshold value of the MOSFET QN1. Thus, a gate voltage of 3 volts is applied to the gate of the MOSFET QN2, and approx. 6 volts is presented at the node N1. On the other hand, since $\overline{R}$/W=5 volts, the MOSFET QN4 is ON and the MOSFET QP3 is OFF, the CMOS inverter is operated, the voltage of the output terminal OUT is inverted by the CMOS inverter, the output node N2 becomes zero volt, and the MOSFET QP1 thus becomes ON. As a result, the voltage of the node N1 is transmitted to the output terminal OUT. Since the MOSFET QN1 becomes OFF when the voltage of the output terminal OUT rises to 3 volts or higher, a current does not flow from the stepped-up output terminal OUT to the input terminal IN. Thus, the voltage of 20 volts of the output terminal OUT is applied to the control gate of the selected row of the memory cell array 1, thereby writing data in the memory cell in accordance with the data input from the I/O circuit 14.

Then, since R/$\overline{W}$=0 volt when the output of the decoder is "0" level, i.e., the input terminal IN is 0 volt, a voltage on the output terminal OUT is not stepped up, the output node NZ of the CMOS inverter is 5 volts, the MOSFET QP1 is maintained in OFF state, and the stepped-up voltage VH is not transmitted to the output terminal OUT. Therefore, no current is flowed from the charge pump circuit 15 to the output stage of the decoder having the output "0".

Then, a reading mode will be described. It is necessary to supply an output voltage corresponding to the input voltage of 5 or 0 volt applied to the input terminal IN to the output terminal OUT. In the reading mode, the MOSFET QX is turned ON, the charge pump circuit 15 does not generate a step-up voltage, and a power source voltage of 5 volts is supplied to the terminal VH. When a voltage on the input terminal IN is 5 volts, since it becomes R/$\overline{W}$=5 volts at this time, no voltage drop occurs in the MOSFET QN1, and this is transmitted to the output terminal OUT. Further, when the input terminal IN is 0 volt, 0 volt appears at the output terminal OUT. Since the MOSFET QN4 is OFF and the MOSFET QP3 is ON due to the R/$\overline{W}$=0 volt, the output node N2 of the CMOS inverter is 5 volts irrespective of the voltage of the output terminal OUT, the MOSFET QP1 thus becomes OFF state, and the voltage of the terminal VH is not presented at the output terminal OUT.

Thus, the voltage of 5 volts is supplied to the control gate in the row selected by the decoder 13 to read information.

Fig. 6 shows a modified embodiment intended to stabilize the operation of the unit circuit in Fig. 5. The points different from the embodiment in Fig. 5 are that an n-channel D-type MOSFET QN5 is inserted between the node N1 and the MOSFET QP1, and an n-channel D-type MOSFET QN6 is inserted between the node N1 and the power source VC.

Since the fundamental operation of this circuit is not different from that in Fig. 5, only the operations of the MOSFETs QN5 and QN6 will be described. When altering from the reading mode to the writing mode, the terminal VH is at the step-up voltage of 20 volts, and when the input terminal IN varies from 5 volts to 0 volt, a DC current flows from the terminal VH to the input terminal IN in the case that the MOSFET QN1 instantaneously varies from 5 volts to 0 volt. The MOSFET QN5 suppresses the flowout of the DC current in this transient state. Thus, it can prevent the step-up voltage supplied to the output terminal OUT when the input terminal IN becomes 5 volts from decreasing.

In case that the voltage of the terminal VH does not sufficiently decrease such as to approx. 10 volts, when altering from the writing mode to the reading mode, the application of the voltage to the output terminal OUT causes an erroneous operation. At this time the MOSFET QN6 becomes ON state under the control of the output node N2 of the CMOS inverter, and even if the voltage of the terminal VH is high, the high voltage is not applied to the output terminal OUT by clamping the voltage of the node N1 to the power source VC.

Since the output node N2 of the CMOS inverter is 0 volt, i.e., the MOSFET QN6 is OFF state in the writing mode using the step-up voltage of 20 volts, no current flows from the terminal VH to the power source VC through this MOSFET QN6.

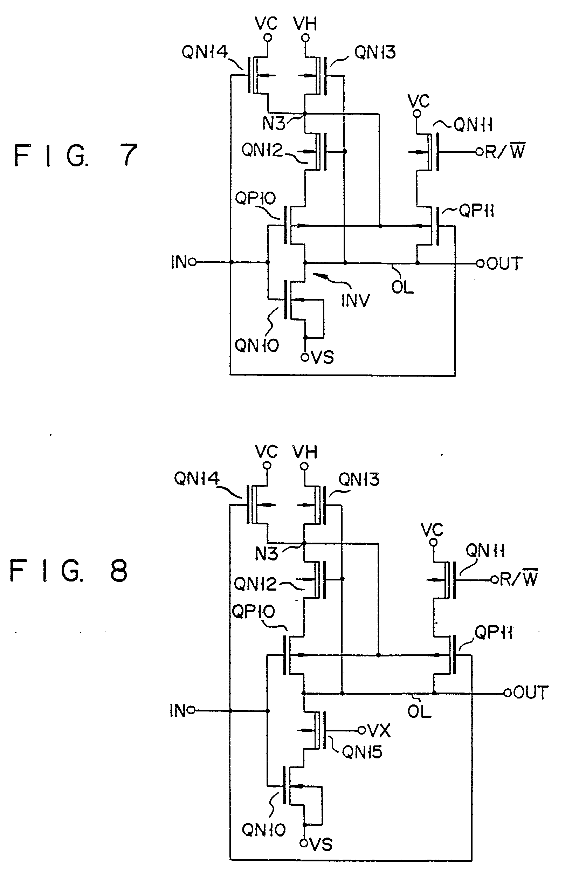

Fig. 7 shows a semiconductor integrated circuit according to another embodiment of the present invention. This circuit has a p-channel MOSFET QP10 and an n-channel MOSFET QN10 forming a CMOS inverter INV and the drains of which are coupled to an output terminal OUT, and a D-type n-channel MOSFET QN11 and a E-type p-channel MOSFET QP11 coupled in series between a power source terminal VC and the output terminal OUT. The source of the MOSFET QN10 is coupled to a ground terminal VS, and the source of the MOSFET QP10 is coupled to a high voltage terminal VH coupled to the output terminal of a charge pump circuit shown in Fig. 2 in series through D-type n-channel MOSFETs QN12 and QN13. The node N3 between the MOSFETs QN12 and QN13 is coupled to the power source terminal VC through a D-type n-channel MOSFET QN14.

The gates of the MOSFETs QP10, QP11, QN10 and QN14 are coupled to an input terminal IN, the gates of the MOSFETs QN12 and QN13 are coupled to the output terminal OUT, and the gate of the MOSFET QN11 is coupled to receive a control signal R/$\overline{W}$. Further, the back gates (a substrate) of the MOSFET QP10 and QP11 are coupled to the node N3.

An operation of the circuit thus constructed will be described. It is first considered the case that the control signal R/$\overline{W}$ is "0" level, i.e., data is to be written in a memory cell, to which the output signal from this circuit is supplied. In this case, a high voltage is applied to the high voltage terminal VH. When an input signal applied to the input terminal IN is set to "0" level (an earth voltage $V_s$=0 volt) in this state, the MOSFET QP10 in the inverter INV becomes ON, and the MOSFET QN10 becomes OFF. After a high voltage of 20 volts is, on the other hand, applied to the high voltage terminal VH, the node N3 is charged toward the 20 volts through the MOSFET QN13. At this time, the gate of the MOSFET QN14 becomes "0" level (0 volt), and the voltage $V_c$ of 5 volts is applied to the source of the MOSFET QN14, and the gate voltage of the MOSFET QN14 is set to −5 volts with respect to the source of the MOSFET QN14. Assume now that the absolute value of the threshold voltage of the MOSFET QN14 is set to 5 volts or lower (also similar in the other D-type MOSFETs), this MOSFET QN14 becomes OFF. Thus, the node N3 charged toward the step-up voltage of 20 volts through the MOSFET QN13 is not discharged by the MOSFET QN14. Therefore, the output terminal OUT is charged toward the step-up voltage of 20 volts through the MOSFET QN12 and the MOSFET QP10. Thus, the MOSFETs QN12 and QN13, the gates of which are connected to an output line OL, are lowered in the impedances between the sources and the drains thereof, and the output line OL is charged toward the step-up voltage of 20 volts. Since the MOSFET QN11 is turned OFF by the control signal R/$\overline{W}$ of "0" volt at this time, the output terminal OUT is not discharged toward the power source voltage through the two MOSFETs QP11 and QN11.

As described above, when the input signal is set to "0" level, a voltage near the step-up voltage is obtained as the output signal. In the memory cell whose control gate is connected to receive this output signal, data is written. When the step-up voltage is obtained as the output signal, the flowout of the current from the high voltage terminal VH, to which the step-up voltage is applied, may be only for charging the output line OL, and the ordinary flowout of the current does not occur.

On the other hand, assume that the input signal becomes "1" ($V_c$=5 volts) this time when the control signal R/$\overline{W}$ is "0" level. In this case, the MOSFET QN10 becomes ON. When the MOSFET QN10 becomes ON, the output line OL is discharged toward the earth voltage $V_s$, and the output signal is set to "0" level. On the other hand, when the input signal is set to "1" level, the MOSFET QN14 is turned ON, and the node N3 is charged to 5 volts. Since the gate of the MOSFET QN13 is set to the earth voltage $V_s$, i.e., 0 volt, the gate voltage with respect to the source side of the MOSFET QN13 which uses the node N3 side as its source is set to −5 volts. Thus, the MOSFET QN13 is cut off. Since the back gates of the two p-channel MOSFETs QP10 and QP11 are connected to the mode N3 charged to 5 volts, the both MOSFET QP10 and QP11 are cut off.

When the input signal is set to "1" level in this manner, the earth voltage $V_s$, i.e., 0 volt is obtained as the output signal. In the memory cell, to which the voltage is applied to the control gate, no variation in the threshold voltage occurs. When 0 volt is obtained as the output signal, the flowout of the current from the high voltage terminal VH becomes only the leakage current.

More specifically, when a high voltage is applied to the high voltage terminal VH and this high voltage is outputted in response to the input signal, the flowout of the current from the high voltage terminal VH is only for temporarily charging the capacity existing in the output line, and the ordinary flowout of the current is prevented.

Then, it is considered the case that data is read out in the memory cell, not shown, to which the output signal from this circuit is supplied. In this case, the control signal R/$\overline{W}$ is set to "1" level. The ordinary voltage $V_c$ of 5 volts is applied to the high voltage terminal VH instead of the high voltage of 20 volts. When the input signal is set to "0" level in this state, the output line OL is charged to 5 volts in series through the MOSFETs QN13, QN12 and QP10. Since the control signal R/$\overline{W}$, on the other hand, becomes "1", the MOSFET QN11 becomes ON. Further, the MOSFET QP11 also becomes ON by the input signal. Thus, the output line OL is charged also through the MOSFETs QN11 and QP11. The reasons for charging the output line OL through the two routes are as follows: When the input signal is switched from "1" level to "0" level or vice versa when the high voltage of 20 volts is applied to the high voltage terminal VH, a penetrating current might temporarily take place between the high voltage terminal VH and the ground terminal VS, with the result that the high voltage might decrease to extremely low level. Thus, the MOSFET QN12 is provided so as to reduce the value of the above-described penetrating current as low as possible. Thus, the charging ability of the output line OL due to the routes of the MOSFETs QN13, QN12 and QP10 is not sufficient. Therefore, the charging operation is also conducted through the routes of the MOSFETs QN11 and QP11 so as to abruptly charge the output line OL to 5 volts.

On the other hand, since the MOSFET QN10 becomes ON and the MOSFET QP11 becomes OFF when the input signal is "1" level, the output line OL is discharged to 0 volt.

In other words, when the control signal R/$\overline{W}$ is set to "1" level, the output signal from this circuit is set to 5 volts or 0 volts in response to the input signal. When the output signal is set to 5 volts, the memory cell, to the control gate of which the output signal of 5 volts is supplied, is set in the selected state, and supplies data previously stored therein, while the memory cell, to the control gate of which the output signal of 0 volt is applied, is set in the nonselected state.

According to the circuit of the embodiment of the invention as described above, the step-up voltage can be supplied to the control gate of the memory cell without the ordinary flowout of the current from the high voltage terminal VH. Further, the value of the temporary penetrating current generated when the input signal is switched can be sufficiently reduced.

Fig. 8 is a circuit diagram showing a semiconductor integrated circuit according to still another embodiment of the present invention. The point of the circuit of this embodiment different from those of the embodiment in Fig. 7 is that a D-type n-channel MOSFET QN15 is connected between an output line OL and an n-channel MOSFET QN10. A predetermined voltage VX higher than 0 volt is applied to the gate of this MOSFET QN15. In the circuit of this embodiment, the direct application of a high voltage to the MOSFET QN10 is prevented by the MOSFET QN15. The reason why a voltage higher than 0 volt is applied to the gate of the MOSFET QN15 is that the breakdown voltage of the MOSFET QN10 becomes lowest when the voltage of the gate is 0 volt. Thus, the voltage of higher than 0 volt is applied to the gate of the MOSFET QN15 to step up the breakdown voltage of the MOSFET QN15, and the direct application of the high voltage to the drain of the MOSFET QN10 is prevented.

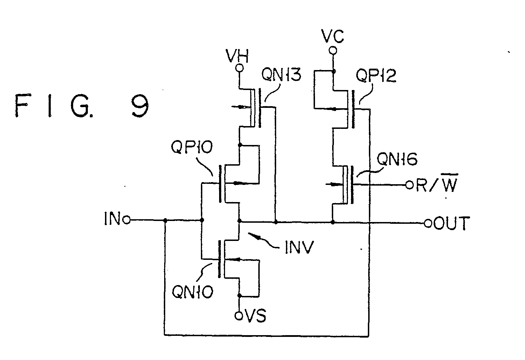

Fig. 9 is a circuit diagram showing a semiconductor integrated circuit according to still another embodiment of the present invention. In the circuit of this embodiment, the two MOSFETs QN12 and QN14 in Fig. 7 are omitted, and the source of the MOSFET QN13 is connected directly to the source of the MOSFET QP 10. Further, the back gate of the MOSFET QP10 is connected to its own source instead of the connection to the node N3. Moreover, an E-type p-channel MOSFET QP12 and a D-type MOSFET QN16 are connected in series between a power source terminal VC and an output line OL instead of the two MOSFETs QN11 and QP11, the gate of one MOSFET QP12 is coupled to an input terminal IN, and a control signal R/$\overline{W}$ is applied to the gate of the other MOSFET QN16.

When the input signal is set to "0" level in case that the control signal R/$\overline{W}$ is now "0" level and a high voltage is applied to the high voltage terminal VH in the circuit arrangement described above, the MOSFET QN10 becomes OFF, and the output lines OL is charged toward the step-up voltage in series through the two MOSFET's QN13 and QP10. More particularly, a high voltage is outputted as the output signal from the output terminal OUT. On the other hand, when the input signal is set to "1" level (5 volts), the MOSFET QN10 becomes ON, and the output line is discharged to ground level. At this time, the gate voltage of the MOSFET QN13 is 0 volt, and when the source voltage of the MOSFET QP10 is charged to the voltage VT1 corresponding to the absolute value of the threshold voltage of the MOSFET QN13, the MOSFET QN13 is cut off. On the other hand, the gate voltage of the MOSFET QP10 is 5 volts at this time, and this back gate is connected to the source of the MOSFET QP10. Thus, if the sum of the source voltage VT1 of this MOSFET QP10 and the threshold voltage of the MOSFET QP10 is set to "1" level of the input, i.e., 5 volts or lower, the MOSFET QP10 is cut off. In other words, even in this embodiment, the flowout of the ordinary current from the high voltage terminal VH can be prevented. In Fig. 9, the backgate of MOSFET QP10 can be connected to the high voltage terminal VH instead of the source of the MOSFET QP10.

When the control signal R/$\overline{W}$ is set to "1" level in the circuit of this embodiment, the output line OL is charged or discharged mainly by the p-channel MOSFET QP12 and the n-channel MOSFET QN10 controlled to ON or OFF in response to the input signal to set the output signal to 5 volts or 0 volt.

The present invention has been described with respect to various embodiments. The present invention is not limited to the particular embodiments described above. For example, in the embodiment shown in Figs. 7 and 8, one terminal of the MOSFETs QP11 and QN11 can be respectively coupled to the power source terminal VC and the output line OL. However, in this case, the back gate of the MOSFET QP11 is coupled not to the note N3 but to the power source terminal VC.

Further, in the embodiments described above, the semiconductor integrated circuit associated with the address decoder has been described. However, any semiconductor integrated circuit may be applied to the present invention if any for controlling the supply of the high voltage in response to the input signal is employed.

**Claims**

1. A semiconductor integrated circuit comprising:

an input terminal (IN) supplied with an input signal;

an output terminal (OUT);

a voltage terminal (VH) supplied with a high voltage;

a reference terminal (VS) set at a reference potential;

a first MOSFET (QN13) of the depletion type and a first channel type which is connected at one end to said voltage terminal (VH) and whose gate is connected to said output terminal (OUT),

characterised by a second MOSFET (QP10) of the enhancement type and a second channel type opposite to said first channel type and which is connected at one end to the other end of said first MOSFET (QN13), and at the other end to said output terminal (OUT), and whose gate is connected to said input terminal (IN); and

a third MOSFET (QN10) of the enhancement type and said first channel type connected between said output terminal (OUT) and said reference terminal (VS) and which has its gate connected to said input terminal (IN) (Fig. 7).

2. A semiconductor integrated circuit according to claim 1, further comprising a fourth MOSFET (QN12) of the depletion type and said first channel type having its gate connected to said output terminal, and having its current path coupled in series between said first and second MOSFETs (QN13, QP10) (Fig. 7).

3. A semiconductor integrated circuit according to claim 2, further comprising a fifth MOSFET (QN14) with its gate coupled to said input terminal, and its current path connected between a power source terminal (VC) and a node between said first and fourth MOSFETs (QN13, QN12) (Fig. 7).

4. A semiconductor integrated circuit according to anyone of claims 1 to 3, comprising a sixth MOSFET (QN15) connected to receive a predetermined voltage (VX) at its gate and coupled between said output terminal and said third MOSFET (QN10) (Fig. 8).

5. A semiconductor integrated circuit according to claim 1, further comprising a seventh MOSFET (QP11) coupled to a power source terminal (VC), the gate of said MOSFET (QP11) being connected to said input terminal.

6. A semiconductor integrated circuit comprising:

an input terminal (IN) supplied with an input signal;

an output terminal (OUT);

a voltage terminal (VH) supplied with a high voltage;

a first depletion type MOSFET (QN1) of a first channel type connected between the input terminal and the output terminal and having its gate connected to a read/write control signal (R/W);

a second depletion type MOSFET (QN2) of the first channel type which is connected at one end to said voltage terminal and whose gate is connected to said output terminal (OUT), a third MOSFET (QP1) which is connected at one end to the other end of said second MOSFET and at the other end to said output terminal; and

inverting means (QP2, QN3) having its input connected to said output terminal, characterized in that said third MOSFET (QP1) is of the enhancement type and of a second channel type opposite to said first channel type and has its gate connected to the output of said inverting means (Fig. 5).

7. A semiconductor integrated circuit according to claim 6, wherein the inverting means comprises at least fourth and fifth MOSFETs (QP2, QN3) coupled to first and second power source terminals (VC, VH), the gate of said fourth MOSFET (QP2) connected to said output terminal (OUT), the node between said fourth and fifth MOSFETs (QP2, QN3) being connected to the gate of said third MOSFET (QP1) (Fig. 5).

8. A semiconductor integrated circuit according to claim 7, further comprising a sixth MOSFET (QN5) coupled at the gate thereof to said output terminal (OUT) and at the current path thereof being connected between said second and third MOSFETs (QN2, QP1), and a seventh MOSFET (QN6) coupled at the gate thereof to the node between said fourth and fifth MOSFETs (QP2, QN3) connected between a power source terminal (VC) and a node between said second and sixth MOSFETs (QN2, QN5) (Fig. 6).

**Patentansprüche**

1. Integrierte Halbleiterschaltung mit:

einem Eingangsanschluß (IN), der mit einem Eingangssignal beaufschlagt ist;

einem Ausgangsanschluß (OUT);

einem Spannungsanschluß (VH), der mit einer Hochspannung versorgt ist;

einem Bezugsanschluß (VS), der auf ein Bezugspotential eingestellt ist;

einem ersten MOSFET (QN13) des Verarmungstyps und eines ersten Kanaltype, der an einem Ende mit dem Spannungsanschluß (VH) verbunden ist und dessen Gate an den Ausgangsanschluß (OUT) angeschlossen ist;

gekennzeichnet durch einen zweiten MOSFET (QP10) des Anreicherungstyps und eines zum ersten Kanaltyp entgegensetzten zweiten Kanaltyps, der an einem Ende mit dem anderen Ende des ersten MOSFETs (QN13) und am anderen Ende mit dem Ausgangsanschluß (OUT) verbunden ist und dessen Gate an den Eingangsanschluß (IN) angeschlossen ist; und

einen dritten MOSFET (QN10) des Anreicherungstyps und des ersten Kanaltyps, der zwischen dem Ausgangsanschluß (OUT) und dem Bezugsanschluß (VS) verbunden ist und dessen Gate an den Eingangsanschluß (IN) angeschlossen ist (Fig. 7).

2. Integrierte Halbleiterschaltung nach Anspruch 1, weiterhin mit einem vierten MOSFET (QN12) des Verarmungstyps und des ersten Kanaltyps, der mit seinem Gate an den Ausgangsanschluß angeschlossen ist und dessen Stromstrecke in Reihe zwischen dem ersten und dem zweiten MOSFET QN13, PQ10) liegt (Fig. 7).

3. Integrierte Halbleiterschaltung nach Anspruch 2, weiterhin mit einem fünften MOSFET (QN14), der mit seinem Gate mit dem Eingangsanschluß gekoppelt ist und dessen Stromstrecke zwischen einem Versorgungsquellenanschluß (VC) und einem Knoten zwischen dem ersten und dem vierten MOSFET (QN13, QN12) verbunden ist (Fig. 7).

4. Integrierte Halbleiterschaltung nach einem der Ansprüche 1 bis 3, mit einem sechsten MOSFET (QN15), der angeschlossen ist, um eine vorbestimmte Spannung (VX) an seinem Gate zu empfangen und der zwischen dem Ausgangsanschluß und dem dritten MOSFET (QN10) gekoppelt ist (Fig. 8).

5. Integrierte Halbleiterschaltung nach Anspruch 1, weiterhin mit einem siebenten MOSFET (QP11), der mit einem Versorgungsquellenanschluß (VC) gekoppelt ist, wobei Gate des MOSFET (QP11) mit dem Eingangsanschluß verbunden ist.

6. Integrierte Halbleiterschaltung mit:

einem Eingangsanschluß (IN), der mit einem Eingangssignal beaufschlagt ist;

einem Ausgangsanschluß (OUT);

einem Spannungsanschluß (VH), der mit einer Hochspannung beaufschlagt ist;

einem ersten Verarmungstyp-MOSFET (QN1) eines ersten Kanaltyps, der zwischen dem Eingangsanschluß und dem Ausgangsanschluß verbunden ist und dessen Gate mit einem Lese/Schreib-Steuersignal (R/W̄) beaufschlagt ist;

einem zweiten Verarmungstyp-MOSFET (QN2) des ersten Kanaltyps, der an einem Ende mit dem Spannungsanschluß verbunden ist und dessen Gate an den Ausgangsachluß (OUT) angeschlossen ist, einem dritten MOSFET (QP1), der an einem mit dem anderen Ende des zweiten MOSFET und am anderen Ende mit dem Ausgangsanschluß verbunden ist; und

einer Invertiereinrichtung (QP2, QN3), die mit ihrem Eingang an den Ausgangsanschluß angeschlossen ist, dadurch gekennzeichnet, daß der dritte MOSFET (QP1) vom Anreicherungstyp und von einem zum ersten Kanaltyp entgegengesetzten zweiten Kanaltyp ist und mit seinem Gate an den Ausgang der Invertiereinrichtung angeschlossen ist (Fig. 5).

7. Integrierte Halbleiterschaltung nach Anspruch 6, bei der die Invertiereinrichtung wenigstens einen vierten und einen fünften MOSFET (QP2, QN3) aufweist, die mit dem ersten bzw. zweiten Versorgungsquellenanschluß (VC, VH) gekoppelt sind, wobei das Gate des vierten MOSFET (QP2) mit dem Ausgangsanschluß verbunden ist und der Knoten zwischen dem vierten und dem fünften MOSFET (QP2, QN3) an das Gate des dritten MOSFET (QP1) angeschlossen ist (Fig. 5).

8. Integrierte Halbleiterschaltung nach Anspruch 7, weiterhin mit einem sechsten MOS-FET (QN5), der an seinem Gate mit dem Ausgangsanschluß (OUT) gekoppelt ist und mit seiner Stromstrecke zwischen dem zweiten und dritten MOSFET (QN2, QP1) liegt, und einem siebenten MOSFET (QN6), der an seinem Gate mit dem Knoten zwischen dem vierten und fünften MOSFET (QP2, QN3) gekoppelt und zwischen einem Verzorgungsquellenanschluß (VC) und einem Knoten zwischen dem zweiten und sechsten MOSFET (QN2, QN5) verbunden ist (Fig. 6).

**Revendications**

1. Circuit intégré semiconducteur comprenant:

une borne d'entrée (IN) recevant un signal d'entrée;

une borne de sortie (OUT);

une borne de tension (VH) recevant une haute tension;

une borne de référence (VS) recevant une tension de référence;

un premier transistor à effet de champ de type MOS (QN13) du type à déplétion à canal d'un premier type qui est connecté par une extrémité à ladite borne de tension (VH) et dont la grille est connectée à ladite borne de sortie (OUT), caractérisé en ce qu'il comporte un second transistor à effet de champ de type MOS (QP10) du type à enrichissement et un second canal d'un type opposé au type dudit premier canal et qui est connecté par une extrémité à l'autre extrémité dudit premier transistor à effet de champ (QN13), et par l'autre extrémité à ladite borne de sortie (OUT), et dont la grille est connectée à ladite borne d'entrée (IN); et

un troisième transistor à effet de champ de type MOS (QN10) du type à enrichissement et à canal dudit premier type connecté entre ladite borne de sortie OUT et ladite borne de référence (VS) et qui à sa grille connectée à ladite borne d'entrée (IN, figure 7).

2. Circuit intégré semiconducteur selon la revendication 1, comprenant de plus un quatrième transistor à effet de champ QN12 du type à déplétion à canal dudit premier type ayant sa grille connectée à ladite borne de sortie, et ayant son chemin de durant connecté en série entre lesdits premier et second transistors à effet de champ (QN13, QP10) (figure 7).

3. Circuit intégré semiconducteur selon la revendication 2, comprenant de plus un cinquième transistor à effet de champ de type MOS (QN14) avec sa grille connectée à ladite borne d'entrée, et son chemin de courant connecté entre une borne d'alimentation de puissance (VC) et un noeud entre lesdits premier et quatrième transistors à effet de champ (QN13, QN12) (figure 7).

4. Circuit intégré semiconducteur selon l'une quelconque des revendications 1 à 3, comprenant un sixième transistor à effet de champ (QN15) connecté de façon à recevoir une tension prédéterminée (VX) sur sa grille et couplée entre ladite borne de tension et ledit troisième transistor à effet de champ (QN10) (figure 8).

5. Circuit intégré semiconducteur selon la revendication 1, comprenant de plus un septième transistor à effet de champ de type MOS (QP11) couplé à une borne d'alimentation de puissance (VC), la grille dudit transistor à effet de champ (QP11) étant connectée à ladite borne d'entrée.

6. Circuit intégré semiconducteur comprenant:

une borne d'entrée (IN) recevant un signal d'entrée;

une borne de sortie (OUT);

une borne de tension (VH) recevant une haute tension;

un premier transistor (QN1) à effet de champ de type MOS à déplétion à canal d'un premier type connecté entre la borne d'entrée et la borne de sortie et ayant sa grille connectée à un signal de contrôle de lecture/écriture (R/W̄);

un second transistor à effet de champ de type MOS à déplétion (QN2) à canal dudit premier type qui est connecté par une extrémité à ladite borne

de tension et dont la grille est connectée à la dite borne de sortie (OUT), un troisième transistor de type MOS à effet de champ (QP1) qui est connecté par une extrémité à l'autre extrémité dudit second transistor à effet de champ et par l'autre extrémité à ladite borne de sortie; et

un moyen inverseur (QP2, QN3) ayant son entrée connectée à ladite borne de sortie, caractérisé en ce que ledit troisième transistor à effet de champ (QP1) est du type à enrichissement à canal d'un second type opposé audit premier type du canal et a sa grille connectée à la sortie dudit moyen inverseur (figure 5).

7. Circuit intégré semiconducteur selon la revendication 6, dans lequel le moyen inverseur comprend au moins un quatrième et un cinquième transistor à effet de champ de type MOS (QP2, QN3) couplés auxdites première et seconde bornes de puissance (VC, VH), la grille dudit quatrième transistor à effet de champ (QP2) étant connectée à ladite borne de sortie (OUT), le noeud entre lesdits quatrième et cinquième transistors à effet de champ (QP2, QN3) étant connecté à la grille dudit troisième transistor à effet de champ (QP1) (figure 5).

8. Circuit intégré semiconducteur selon la revendication 7, comprenant de plus un sixième transistor (QN5) à effet de champ de type MOS couplé par la grille à ladite borne de sortie (OUT) et dont le chemin de courant est connecté entre lesdits second et troisième transistors à effet de champ (QN2, QP1) et un septième transistor à effet de champ de type MOS (QN6) dont la grille est couplée au noeud entre lesdits quatrième et cinquième transistors à effet de champ (QP2, QN3), le dit septième transistor (QN6) étant connecté entre une borne d'alimentation de puissance (VC) et un noeud entre lesdits second et sixième transistors à effet de champ (QN2, QN5) (figure 6).

F I G. 1A

F I G. 1B

F I G. 1C

F I G. 1D

FIG. 2

VC

QR

Q1  Q2  Q3  Qn

QX  R/W̄

VC

VO

φ1  ~C1  ~C2  ~C3  ~Cn

φ2

FIG. 3A

FIG. 3B

EP 0 137 245 B1

F I G. 4

# F I G. 5

# F I G. 6

F I G. 7

F I G. 8

F I G. 9